# EUROPÄISCHE PATENTANMELDUNG

(11) **EP 4 340 225 A2**
(43) Veröffentlichungstag der Anmeldung: **20.03.2024**
(21) Anmeldenummer: 23195339.9
(22) Anmeldetag: 05.09.2023
(51) Int. Cl.: H03K 17/96

(54) **ELEKTRONISCHER SIGNALTASTER**

(30) Priorität: 19.09.2022 DE 102022003446
(71) Anmelder: Emken, Georg, 26203 Wardenburg (DE)
(72) Erfinder: Emken, Georg, 26203 Wardenburg (DE)
(74) Vertreter: Heiland, Karsten

(57) **Zusammenfassung**

Die Erfindung betrifft die Entwicklung eines elektronischen Signaltasters, der als aktives Schaltelement zur Signalerzeugung entwickelt wurde und die Funktion ohne zusätzliche Spannungsversorgung leisten kann. Damit kann eine elektronische Steuerfunktion ausgelöst werden, ohne einen mechanischen Kontakt und auch ohne einen dauerhaft bestromten Sensor, wie z.B. einem kapazitiven Sensor. Die Funktion der Erfindung basiert auf dem Einsatz eines Piezoelements, das bei der Tastbetätigung ein elektrisches Signal erzeugt. Dabei ist nur ein sehr kurzer Betätigungshub, maximal einige 1/100 mm erforderlich. Durch den Aufbau als Tastelement mit der entwickelten Betätigungsart, wird ein großes Einsatzgebiet ermöglicht, wobei der Signaltaster insbesondere in PKWs für Öffnungs- und Schließfunktionen eingesetzt werden kann. Des Weiteren kann der elektronische Signaltaster für Einzelfunktionen im allgemeinen Gerätebedienbereich zur Erfassung der Tastbetätigung eingesetzt werden. Ein wichtiges Merkmal dabei ist, dass die erforderliche Kraft, um ein Signal auszulösen, in einem begrenzten Betätigungskraftbereich eingesetzt werden kann. Die Einstellung der Betätigungskraft kann in verschiedener Weise erfolgen, wie z.B. ein Bereich mit Minimal- und Maximalwert, Mindestbetätigungskraft oder weitere Auswertungsmethoden.

## Beschreibung

Signaltaster werden in vielen Bereichen, insbesondere im Automobilbereich, als mechanische oder elektronische Taster, mit der dafür erforderlichen Spannungsversorgung, eingesetzt. Bei den mechanischen Schaltern handelt es sich um aufwendigere Bauteile mit der Einschränkung der mechanischen Lebensdauer und der reduzierten elektrischen Funktion. Dazu sind mechanische Zusatzaufwendungen für die Einstellung einer Mindestbetätigungskraft erforderlich, wie in EP1 808 877 A2 ausgeführt. Die elektronischen Taster benötigen in der Regel eine Spannungsversorgung und sind deshalb als elektrische Permanentverbraucher nicht für den Einsatz im Pkw prädestiniert. Damit sind diese elektronischen Sensoren ebenfalls aufwendiger in der Realisierung und mit Einschränkungen für die Sensorik einsetzbar.

Damit ergibt sich die Anforderung, einen elektronischen Signaltaster mit spezifizierbaren Betätigungskräften, mit hoher Lebensdauer, einem möglichst geringen Betätigungshub, vorzugsweise maximal einige hundertstel Millimeter, und einer robusten Ausführung zu entwickeln.

Zur Lösung der Aufgabe weist ein elektronischer Signaltaster die Merkmale des Anspruchs 1 auf. Weitere Merkmale der Erfindung ergeben sich aus der Beschreibung im Übrigen und den Unteransprüchen.

Der elektronische Signaltaster weist einen Piezo-Sensor und eine Erkennungsschaltung auf, wobei der Piezo-Sensor zur Aufnahme einer Druckkraft vorgesehen ist und eine elektrische Spannung in Abhängigkeit von der Druckkraft abgibt. Insbesondere gibt die Erkennungsschaltung aufgrund der elektrischen Spannung ein elektrisches Signal aus, sofern die Druckkraft einen Schwellwert von beispielsweise 10 N überschreitet. Die Erkennungsschaltung ist entsprechend ausgebildet. Vorzugsweise gibt die Erkennungsschaltung nur dann ein elektrisches Signal aus, wenn die Druckkraft den Schwellwert überschreitet und insbesondere unterhalb eines Schwellwertmaximums bleibt. Die elektrische Spannung des Sensors steigt mit der Druckkraft an. Demgegenüber wird das elektrische Signal von der Erkennungsschaltung erst ausgegeben, wenn die Druckkraft, insbesondere auch die elektrische Spannung, den Schwellwert überschreitet. Das elektrische Signal kann eine Signalspannung für eine Schaltung zur Bereitstellung eines Arbeitsstroms, eine Steuerspannung zur Bereitstellung eines Steuerstroms, eine Versorgungsspannung zur Bereitstellung eines Arbeitsstroms oder ein anderes elektrisches Signal sein.

Erfindungsgemäß kann das elektrische Signal eine Signalspannung von beispielsweise 12 V oder ein Schaltstrom sein. Der Schaltstrom kann beispielsweise ein Steuerstrom für ein Relais oder ein Arbeitsstrom für eine elektromagnetische Betätigung sein, insbesondere für einen Schließmechanismus in einem Fahrzeug oder an einer Maschine, einem Gebäude oder für einen anderen Zweck.

Erfindungsgemäß kann der Signaltaster mit einem Stößel versehen sein, welcher mit einem Angriffspunkt bei Betätigung den Sensor beaufschlagt. Durch geeignete Konstruktion des Stößels kann der Sensor in definierter Weise beaufschlagt werden, etwa durch geeignete Dimensionierung.

Erfindungsgemäß können eine Tastwegbegrenzung, insbesondere eine Auflage am Stößel und eine Auflage an einem Gehäuse des Signaltasters vorgesehen sein, wobei die beiden Auflagen bei Betätigung des Stößels aneinander zur Anlage kommen und so eine sich aus der Betätigung ergebene Kraftwirkung auf den Sensor begrenzen. Das heißt, bei Betätigung des Stößels liegt dieser am Sensor an, während zugleich die beiden Auflagen zur Anlage kommen. Dadurch wirkt die Betätigungskraft nicht allein auf den Sensor. Es ergibt sich eine Begrenzung des Tastweges und so auch eine Begrenzung der Kraftwirkung.

Erfindungsgemäß kann auch ein Deckel mit Betätigungselement zur Beaufschlagung des Sensors vorgesehen sein. Der Deckel kann fest am Gehäuse gehalten oder relativ zu diesem bewegbar sein. Auch kann das Betätigungselement im oder am Deckel fest angeordnet oder relativ zum Deckel bewegbar sein.

Erfindungsgemäß kann im Deckel eine Membran vorgesehen sein, wobei das Betätigungselement von der Membran gehalten und relativ zum Deckel im Übrigen bewegbar ist. Die Membran ist vorzugsweise zugleich Oberseite des Deckels oder umlaufende Einfassung für das Betätigungselement. Die Membran soll die Bewegung des Betätigungselements relativ zum Deckel im Übrigen ermöglichen.

Erfindungsgemäß kann die Membran mit dem Deckel auf einem Gehäuse zur Aufnahme des Sensors den Signaltaster hermetisch abdichten. Das Gehäuse nimmt den Sensor auf und wird vom Deckel abgedeckt. Die Membran dichtet den Übergang vom Betätigungselement zum Deckel im Übrigen ab. Vorzugsweise ist auch ein Übergang zwischen Deckel und Gehäuse hermetisch dicht, ebenso Deckel und Gehäuse selbst. Für elektrische Kontakte sind dann vorzugsweise hermetisch abgedichtete Durchführungen vorhanden.

Erfindungsgemäß können Federkontakte zur elektrischen Kontaktierung des Sensors vorgesehen sein, wobei die Federkontakte beim Zusammenbau des Signaltasters den Sensor ohne zusätzliche Verbindungstechnik direkt kontaktieren. Das heißt, die Federkontakte liegen vorzugsweise nur mit Kraftschluss am Sensor an.

Erfindungsgemäß kann wenigstens eine Aussparung am Gehäuse zur Aufnahme eines oder mehrerer Federkontakte, SMD-Kontakte oder anderer Kontakte vorgesehen sein. Vorzugsweise ist die Innenkontur des Deckels an die Außenkontur des Gehäuses ohne Überstände angepasst. Die wenigstens eine Aussparung ist insbesondere nur am Gehäuse vorgesehen, nicht am Deckel.

Erfindungsgemäß kann wenigstens eine Aussparung am Stößel zur Aufnahme wenigstens einer isolierten Litze oder eines anderen elektrischen Kontakts vorgesehen sein. Dies ermöglicht eine weitgehend freie Ausgestaltung des Stößels.

Gegenstand der Erfindung ist auch ein Fahrzeug gemäß Anspruch 12, nämlich mit einem erfindungsgemäßen Signaltaster. Bei dem Fahrzeug handelt es sich vorzugsweise um ein Landfahrzeug, insbesondere einen PKW.

Nach einem weiteren Gedanken der Erfindung können eine Tür oder Klappe des Fahrzeugs mit einem erfindungsgemäßen Signaltaster versehen sein. Dabei können die Tür oder die Klappe den Signaltaster selbst aufweisen oder der Signaltaster ist am Fahrzeug an anderer Stelle angeordnet und als Bedienungselement für die Tür oder die Klappe vorgesehen.

Erfindungsgemäß kann eine Fahrzeugaußenhaut einen darunter anliegenden Signaltaster aufweisen. Fahrzeugaußenhaut in diesem Sinne ist vorzugsweise ein Türblech, Karosserieblech oder eine Kunststofflage oder Kunststoffverkleidung, ein Außenblech oder kohlefaserverstärkter Kunststoff.

Erfindungsgemäß kann der Signaltaster in einem Träger gehalten sein, etwa einem Türträger, einem Rahmen als Träger eines Außenblechs, einer Kunststoffverkleidung oder Fahrzeugaußenhaut.

Erfindungsgemäß kann eine optisch oder tastend erkennbare Markierung für einen Betätigungsbereich auf einer Oberfläche über dem Signaltaster vorhanden sein. Die Markierung ist vorzugsweise auf der Fahrzeugaußenhaut oder auf der Tür oder Klappe vorgesehen. Optisch erkennbar ist beispielsweise eine von der Oberfläche im Übrigen abweichende Farbgebung. Tastend erkennbar ist beispielsweise eine mit Rillen, Wülsten, Erhebungen oder anderen Abweichungen versehene Oberfläche, die um den Betätigungsbereich herum keine Abweichungen aufweist.

Erfindungsgemäß wurde ein elektronischer Signaltaster entwickelt, der in Bezug auf einen sehr geringen Hub, spezifizierbare Betätigungskraft und ohne erforderliche Spannungsversorgung realisiert wurde. Zusätzlich wird der Sensor insbesondere in der Weise aufgebaut, dass eine mechanische Überbelastung des Sensors mit vorgesehenen Betätigungsmitteln nicht auftreten kann.

Der elektronische Signaltaster wurde als aktives Schaltelement zur Signalerzeugung entwickelt und kann die Funktion ohne zusätzliche Spannungsversorgung leisten. Damit kann eine elektronische Steuerfunktion ausgelöst werden, ohne einen mechanischen Kontakt und auch ohne einen dauerhaft bestromten Sensor, wie z.B. bei einem kapazitiven Sensor. Die Funktion der Erfindung basiert auf dem Einsatz eines Piezoelements, das bei der Tastbetätigung ein elektrisches Signal erzeugt. Dabei ist nur ein sehr kurzer Betätigungshub, maximal einige 1/100 mm erforderlich. Durch den Aufbau als Tastelement mit der entwickelten Betätigungsart, wird ein großes Einsatzgebiet ermöglicht, wobei der Signaltaster insbesondere in PKWs für Öffnungs- und Schließfunktionen eingesetzt werden kann. Des Weiteren kann der elektronische Signaltaster für Einzelfunktionen im allgemeinen Gerätebedienbereich zur Erfassung der Tastbetätigung eingesetzt werden. Ein wichtiges Merkmal dabei ist, dass die erforderliche Kraft, um ein Signal auszulösen, in einem begrenzten Betätigungskraftbereich eingesetzt werden kann. Die Einstellung der Betätigungskraft kann in verschiedener Weise erfolgen, wie z.B. ein Bereich mit Minimal- und Maximalwert, Mindestbetätigungskraft oder weitere Auswertungsmethoden.

Vorteilhafte Ausführungsformen der Erfindung werden nachfolgend anhand von Zeichnungen erläutert. Es zeigen:
- Fig. 1: eine Explosionsdarstellung einer ersten Ausführungsform eines Signaltasters ohne Erkennungsschaltung, mit durch einen Deckel zugänglichem Stößel,
- Fig. 2: einen Schnitt durch den Signaltaster gemäß Fig. 1,
- Fig. 3: eine Explosionsdarstellung einer zweiten Ausführungsform des Signaltasters, mit Betätigungselement im Deckel,
- Fig. 4: einen Schnitt durch den Signaltaster gemäß Fig. 3,
- Fig. 5: eine Explosionsdarstellung einer dritten Ausführungsform des Signaltasters, analog zu Fig. 1 und 3, jedoch mit speziellen Federkontakten,
- Fig. 6: ein Fahrzeug (Pkw) mit Beispielen für die Anordnung des Signaltasters,
- Fig. 6a: einen vergrößerten Ausschnitt Z aus Fig. 6,
- Fig. 6b: einen Schnitt durch den Ausschnitt Z in Fig. 6a,
- Fig. 7: ein vereinfachtes Schaltbild eines Signaltasters mit Erkennungsschaltung.

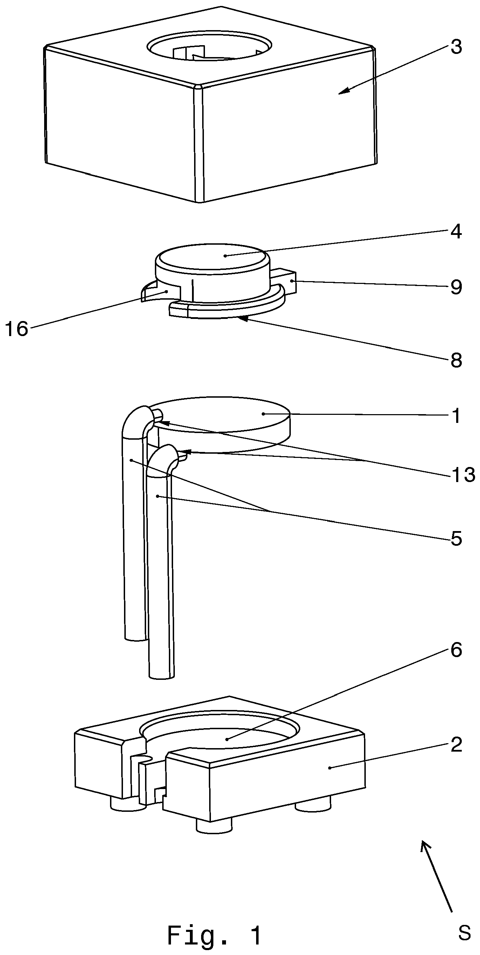

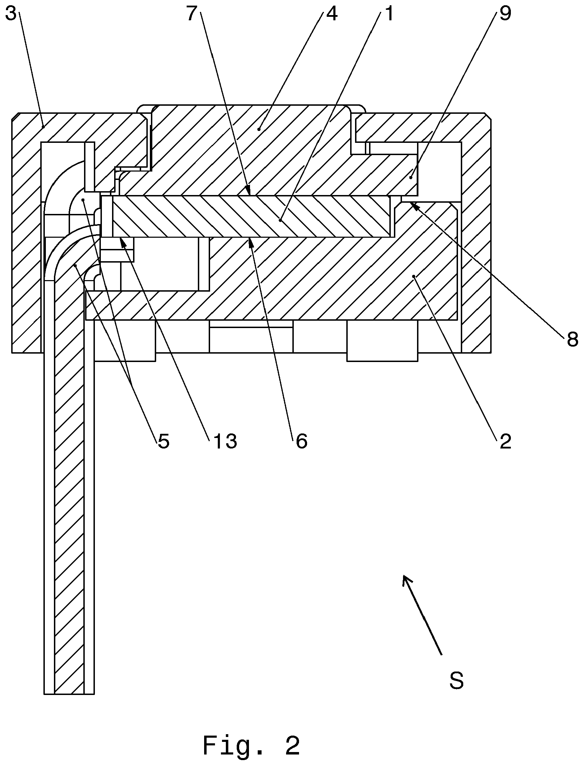

Die Funktion eines elektronischen Signaltasters S gemäß Fig. 1, 2 wird mit dem Piezoeffekt auf Basis eines Halbleiters realisiert, wobei ein Piezo-Sensor 1 durch Kraftbeaufschlagung eine elektrische Spannung abgibt. Diese Spannung ist abhängig von der Höhe der Kraft, die auf den Sensor 1 einwirkt. Der Sensor 1 kann in der Ausführungsart für verschiedene Kraftbereiche eingestellt werden, so dass unterschiedliche Anwendungsbereiche abgedeckt werden können. Um eine genau definierte Betätigung zu erreichen, wird der Sensor 1 in einem Gehäuse 2 mit möglichst voller Auflagefläche 6 gelagert.

Bei der Ausführung nach Fig. 1, 2 erfolgt die Betätigung mit einem in einer Öffnung eines Deckels 3 bewegbaren Stößel 4, der eine genau auf den Sensor 1 abgestimmte Kontur für einen Angriffspunkt 7 am Sensor 1 aufweist. Durch die Betätigung des Stößels 4 wird ein Hub von maximal einigen 1/100 Millimeter ausgeführt, um ein Betätigungssignal an Leitungen, hier Litzen 5, zu erzeugen.

Fakultativ kann der Stößel 4 um eine dargestellte Auflagefläche 9 erweitert werden, welche gegenüber einer Auflagefläche 8 am Gehäuse 2 angeordnet ist, so dass die mechanische Auflage des Stößels 4 auf das Gehäuse 2 auf den äußeren Durchmesser erweitert wird und damit eine noch höhere Betätigungskraft des Tasters ermöglicht. Der sehr kurze Hub des Stößels 4 wird durch einen Kontakt der Auflageflächen 8, 9 miteinander begrenzt. In Fig. 2 ist der Abstand zwischen den Auflageflächen 8, 9 im unbetätigten Zustand zur Verdeutlichung übertrieben groß dargestellt.

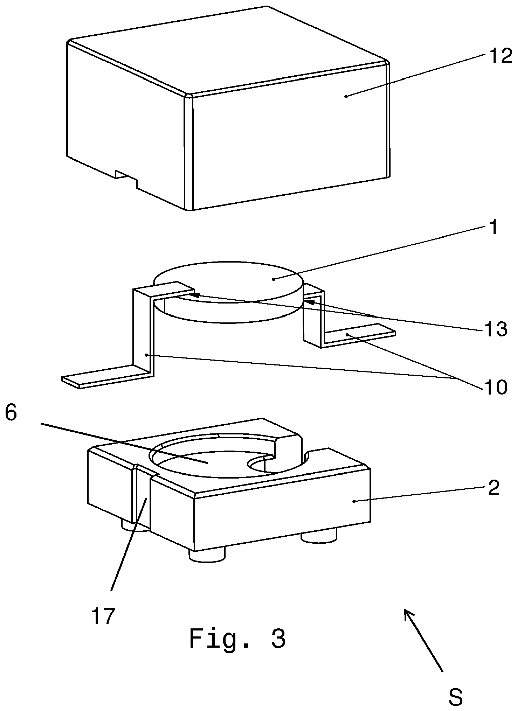

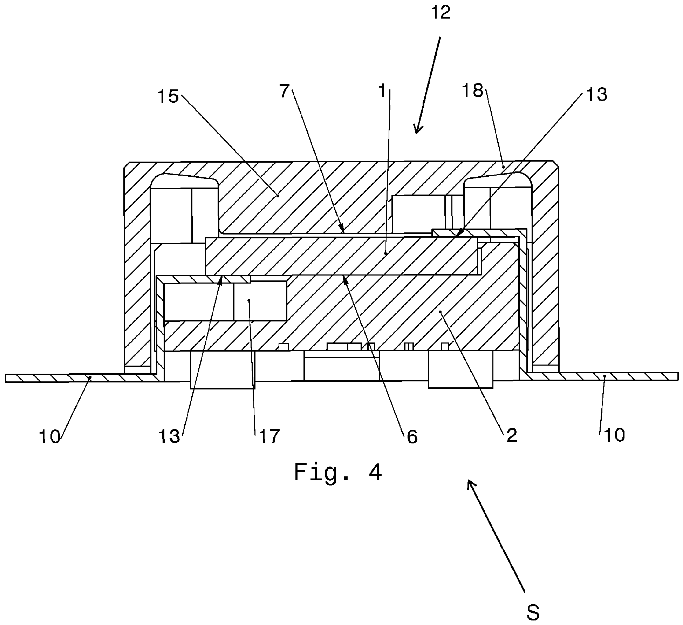

Die elektrische Kontaktierung des Sensors kann gemäß Fig. 1, 2 durch die isolierten Litzen 5 oder gemäß Fig. 3, 4 durch zwei Anschlüsse, insbesondere SMD-Anschlüsse 10, erfolgen, die isoliert voneinander verlegt und vorzugsweise mittels Löten oder Schweißen als Verbindungstechnik 13 am Sensor 1 kontaktiert werden.

In der Ausführung gemäß Fig. 3, 4 wird der elektronische Signaltaster S mit einem Deckel 12 ausgeführt, der ein integriertes Betätigungselement 15 aufweist, welches durch eine Membrane 18 mit dem Deckel 12 verbunden ist, siehe Fig. 4. Durch das Betätigungselement 15 wird die Betätigungskraft an den Sensor 1 geleitet. Dabei braucht die Membrane 18 maximal mit nur einigen 1/100 Millimeter betätigt werden, damit ein elektrisches Betätigungssignal erzeugt wird. Durch diese Ausführungsart kann speziell im Feuchtbereich, wie z.B. die Außenhaut 21 eines PKWs und Maschinen aller Art, der elektronische Signaltaster S ohne Zusatzaufwand für die Abdichtung gegen Feuchtigkeit und Verschmutzung, eingesetzt werden. Dabei ist gewährleistet, dass eine unbeabsichtigte Betätigung nicht passieren kann, weil eine spezifizierte Mindestkraft für das Schalten und für die Generierung eines elektrischen Signals erforderlich ist. Erreicht wird dies durch eine mit dem Sensor 1 verbundene oder in den Sensor 1 integrierte Erkennungsschaltung S, wie sie beispielhaft weiter unten beschrieben wird.

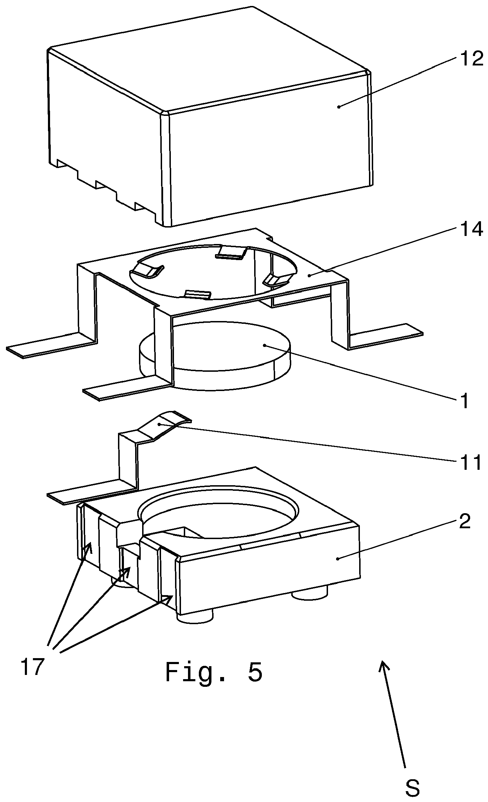

Die Ausführung gemäß Fig. 5 ist mit einer Kontaktierung durch zwei Federkontakte 11, 14 ausgeführt. Bei der Montage im Gehäuse 2 erfolgt die Kontaktierung durch den Federdruck nach dem Montieren der vorzugsweise als Stanzgitterteile ausgeführten Federkontakte 11, 14 durch das Fixieren des Deckels 12 gemäß Fig. 3, 4 oder des Deckels 3 gemäß Fig. 1, 2. Dazu können weitere übliche Kontaktierungsverbindungen genutzt werden, die mit der Verbindungstechnik Löten, Schweißen, Federkontakten oder einfache Anpresskraft, ausgeführt werden können.

In den verschiedenen Ausführungsbeispielen können Deckel 3, Gehäuse 2 und/oder Stößel 4 eine oder mehrere Aussparungen 16, 17 zur Aufnahme und/oder Führung der Litzen 5 und Kontakte 10, 11, 14 aufweisen.

Das vom Signaltaster S erzeugte elektrische Signal kann als "Aufwecksignal" für die Elektronik im PKW oder auch in anderen elektronischen oder elektrischen Anwendungen genutzt werden. Der Signaltaster S erzeugt das elektrische Signal ohne zusätzliche Stromversorgung des Sensors 1 und stellt die Energie bereit, um ein Gerät, wie z.B. ein Steuergerät, elektronisch zu starten. Dies ist ein wichtiger Vorteil in den Einsatzgebieten von Maschinen und Fahrzeugen, insbesondere PKWs allgemein.

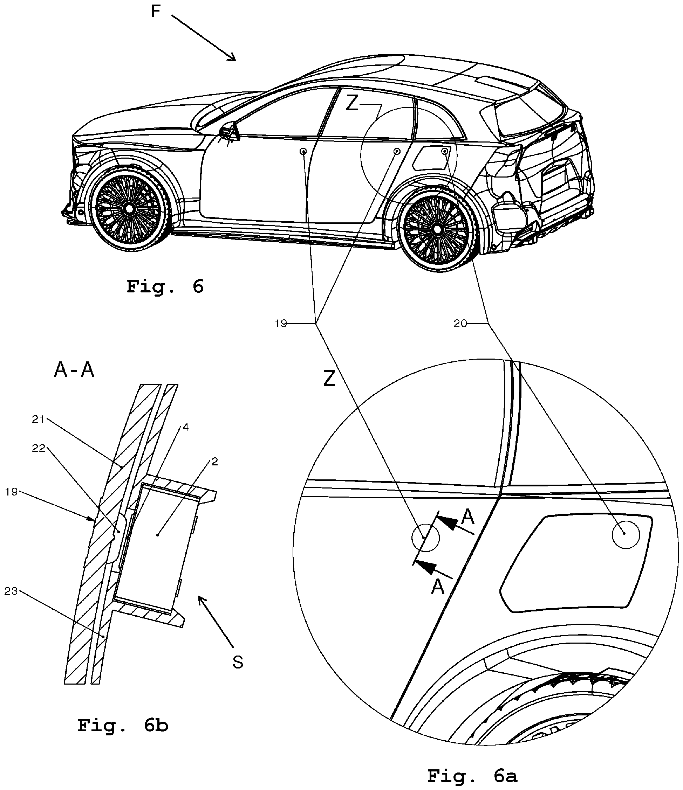

Fig. 6 zeigt einen PKW mit drei Beispielen für die Anordnung des Signaltasters S, nämlich unter bzw. hinter Bestätigungsbereichen 19, 20. Die Betätigungsbereiche 19 liegen in der Nähe von nicht gezeigten Türschlössern von vorderer Tür und hinterer Tür. Der Betätigungsbereich 20 liegt auf einer Tankklappe, kann aber auch daneben angeordnet sein.

Der Betätigungsbereich 19 ist zugleich Oberfläche einer Türaußenhaut 21, welche an ihrer Rückseite mit einem Türträger 23 versehen ist. Türträger 23 und Türaußenhaut 21 sind fest miteinander verbunden, so dass der Türträger 23 die Türaußenhaut 21 spannt und/oder stabilisiert. Fig. 6b lässt einen schmalen Spalt zwischen Türträger 23 und Türaußenhaut 21 erkennen. Dieser Spalt ist übertrieben dargestellt und allenfalls abschnittsweise vorhanden.

Die Türaußenhaut 21 ist hier vorzugsweise ein Stahlblech, Aluminiumblech, eine oder mehrere Kunststofflagen, mit oder ohne Glasfaserverstärkung bzw. Kohlefaser.

Der Signaltaster S ist am Türträger 23 - zur Fahrzeugmitte hin - ortsfest gehalten, etwa in einem Aufnahmefach. Der Türträger 23 weist eine kleine Öffnung auf, durch die der Stößel 4 und/oder der Deckel 12 aus Richtung der Türaußenhaut 21 zugänglich sind. Die Türaußenhaut 21 weist innenseitig - zum Türträger 23 hin - ein Betätigungselement 22 auf, welches in die genannte Öffnung hineinragen kann. Dem Betätigungselement 22 gegenüberliegend weist die Türaußenhaut 21 den Betätigungsbereich 19 auf, welcher außen mit einer Markierung versehen sein kann. Gemäß Fig. 6b besteht die Markierung in einer strukturierten Oberfläche im Betätigungsbereich 19.

Ein Druck auf die Türaußenhaut 21 im Betätigungsbereich 19 bewegt das Betätigungselement 22 gegen den Stößel 4 oder Deckel 12, so dass auf den Sensor 1 eine Kraft ausgeübt wird und nach Überschreiten eines Schwellwerts ein elektrisches Signal vom Signaltaster S ausgegeben wird. Das elektrische Signal wird von einem nicht gezeigten Steuergerät ausgewertet. Letzteres öffnet die betreffende Tür mittelbar durch Ansteuerung eines nicht gezeigten elektromagnetischen Türöffners. Analog ist das Öffnen der Tankklappe durch Druck auf den Betätigungsbereich 20 möglich.

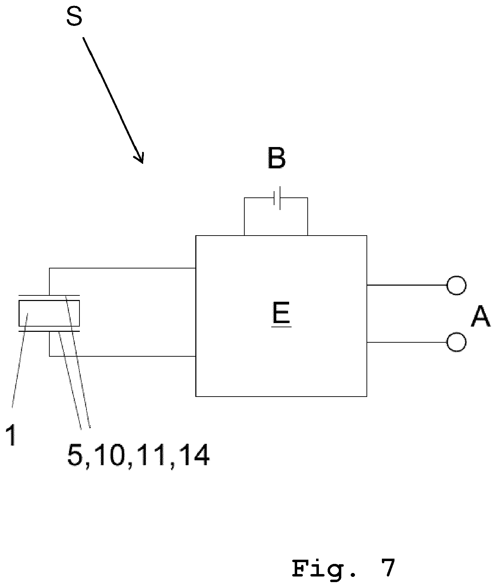

Gemäß Fig. 7 kann der Signaltaster S mit einer Erkennungsschaltung E versehen sein. Letztere erhält als Eingangsspannung die Ausgangsspannung des Sensors 1 und ist selbst an ein Bordnetz B angeschlossen, beispielsweise an das Bordnetz des in Fig. 6 gezeigten Fahrzeugs F. Mit der Erkennungsschaltung E wird die Ausgangsspannung des Sensors 1 ausgewertet. Sofern die Ausgangsspannung einen vorgegebenen Grenzwert überschreitet und insbesondere unterhalb eines oberen Grenzwerts bleibt, gibt die Erkennungsschaltung E an ihren Ausgängen A ein elektrisches Signal ab, welches von einem nicht gezeigten Steuergerät ausgewertet werden kann oder unmittelbar elektromagnetische Bauteile ansteuert.

Es wurde ein elektronischer Signaltaster S entsprechend Fig. 1 bis Fig. 7 entwickelt, der für die Anwendung als stromlos betreibbarer Signalgeber funktioniert und mit spezifizierbaren Betätigungskräften, mit hoher Lebensdauer, einem möglichst geringen Betätigungshub von maximal einigen hundertstel Millimeter und einer robusten Ausführung. Der elektronische Signaltaster S, bestehend aus einem Piezo-Sensorelement, mit einem Gehäuse, einem Stößel oder einer Membranbetätigung und rationellen Anschlusslösungen ist für die sichere Aktivierung von Steuervorgängen, z.B. in PKWs, geeignet.

### Bezugszeichenliste (als Teil der Beschreibung)

| | | | |
|---|---|---|---|
| 1 | Sensor | 21 | Türaußenhaut |
| 2 | Gehäuse | 22 | Betätigungselement |
| 3 | Deckel | 23 | Türträger |
| 4 | Stößel | | |
| 5 | Isolierte Litzen | | |
| 6 | Auflage am Gehäuse 2 für den Sensor 1 | A | Ausgang |
| 7 | Angriffspunkt des Stößels 4 bzw. | B | Bordnetz |
| | des Betätigungselements 15 am | E | Erkennungsschaltung |
| | Sensor 1 | F | Fahrzeug |
| 8 | Auflage am Gehäuse 2 für den Stößel 4 | S | Signaltaster |
| 9 | Auflage am Stößel 4 | | |
| 10 | SMD-Kontakte | | |
| 11 | Federkontakt I | | |
| 12 | Deckel mit Betätigungselement 15 | | |
| 13 | Verbindungstechnik | | |
| 14 | Federkontakt II mit mehrfachen Kontaktpositionen | | |
| 15 | Betätigungselement am Deckel 12 | | |
| 16 | Aussparung am Stößel 4 | | |
| 17 | Aussparung am Gehäuse 2 | | |
| 18 | Membrane | | |
| 19 | Betätigungsbereich Tür | | |
| 20 | Betätigungsbereich Tankklappe | | |

## Patentansprüche

1. Elektronischer Signaltaster (S), mit Piezo-Sensor (1) und Erkennungsschaltung (E), wobei der Piezo-Sensor (1) zur Aufnahme einer Druckkraft vorgesehen ist und eine elektrische Spannung in Abhängigkeit von der Druckkraft abgibt, und wobei die Erkennungsschaltung (E) aufgrund der elektrischen Spannung ein elektrisches Signal ausgibt, sofern die Druckkraft einen Schwellwert überschreitet.

2. Elektronischer Signaltaster (S) nach Anspruch 1, **dadurch gekennzeichnet, dass** das elektrische Signal eine Signalspannung oder ein Schaltstrom ist.

3. Elektronischer Signaltaster (S) nach Anspruch 1 oder 2, **gekennzeichnet durch** einen Stößel (4), welcher mit einem Angriffspunkt (7) bei Betätigung den Sensor (1) beaufschlagt.

4. Elektronischer Signaltaster (S) nach Anspruch 3, **gekennzeichnet durch** eine Tastwegbegrenzung, insbesondere eine Auflage (9) am Stößel und eine Auflage (8) an einem Gehäuse, wobei die beiden Auflagen (8,9) bei Betätigung des Stößels (4) aneinander zur Anlage kommen und so eine sich aus der Betätigung ergebende Kraftwirkung auf den Sensor (1) begrenzen.

5. Elektronischer Signaltaster (S) nach einem der Ansprüche 1-4, **gekennzeichnet durch** einen Deckel (12) mit Betätigungselement (15) zur Beaufschlagung des Sensors (1).

6. Elektronischer Signaltaster (S) nach Anspruch 5, **gekennzeichnet durch** eine Membran (18) im Deckel (12), wobei das Betätigungselement (15) von der Membran (18) gehalten und relativ zum Deckel (12) im Übrigen bewegbar ist.

7. Elektronischer Signaltaster (S) nach Anspruch 6, **dadurch gekennzeichnet, dass** die Membran (18) mit dem Deckel (12) auf einem Gehäuse (2) zur Aufnahme des Sensors (1) den Signaltaster hermetisch abdichtet.

8. Elektronischer Signaltaster (S) nach einem der Ansprüche 1-7, **gekennzeichnet durch** SMD-Kontakte (10) zur elektrischen Kontaktierung des Sensors (1).

9. Elektronischer Signaltaster (S) nach einem der Ansprüche 1-8, **gekennzeichnet durch** Federkontakte (11,14) zur elektrischen Kontaktierung des Sensors (1), wobei die Federkontakte (11,14) beim Zusammenbau des Signaltasters den Sensor (1) ohne zusätzliche Verbindungstechnik direkt kontaktieren.

10. Elektronischer Signaltaster (S) nach einem der Ansprüche 1-9, **gekennzeichnet durch** wenigstens eine Aussparung (17) an einem Gehäuse (2) zur Aufnahme eines oder mehrerer Federkontakte (11,14), SMD-Kontakte (10) oder eines anderen elektrischen Kontakts.

11. Elektronischer Signaltaster (S) nach Anspruch 3 oder 4, **gekennzeichnet durch** wenigstens eine Aussparung (16) am Stößel (4) zur Aufnahme wenigstens einer isolierten Litze (5) oder eines anderen elektrischen Kontakts.

12. Fahrzeug (F), insbesondere Landfahrzeug, vorzugsweise Pkw, mit einem Signaltaster (S) nach einem der Ansprüche 1-11.

13. Fahrzeug (F) gemäß Anspruch 12, **gekennzeichnet durch** eine Tür oder Klappe (20) mit einem Signaltaster (S) nach einem der Ansprüche 1-11.

14. Fahrzeug (F) gemäß Anspruch 12, **gekennzeichnet durch** eine Fahrzeugaußenhaut (21) mit einem darunter anliegenden Signaltaster (S) nach einem der Ansprüche 1-11.

15. Fahrzeug (F) gemäß Anspruch 12, **gekennzeichnet durch** einen Träger (23) mit einem darin gehaltenen Signaltaster (S) nach einem der Ansprüche 1-11.

16. Fahrzeug (F) nach einem der Ansprüche 12-15, **gekennzeichnet durch** eine optisch oder tastend erkennbare Markierung für einen Betätigungsbereich (19) auf einer Oberfläche über dem Signaltaster (S).
